Europäisches Patentamt

European Patent Office

Office européen des brevets

(19)

(11)　EP 0 872 954 B1

(12)　　FASCICULE DE BREVET EUROPEEN

(45) Date de publication et mention
de la délivrance du brevet:
**27.10.2004　Bulletin 2004/44**

(51) Int Cl.⁷: **H03H 9/64**, H03H 9/02

(21) Numéro de dépôt: **98400915.9**

(22) Date de dépôt: **14.04.1998**

(54) **Dispositif à ondes acoustiques de surface à couplage par proximité à entrées/sorties différentielles**

Akustische Oberflächenwellenanordnung mit Nahfeldkopplung und differentiellen Ein- und Ausgängen

Surface acoustic wave device with proximity coupling and with differential inputs and outputs

(84) Etats contractants désignés:
**DE FI FR GB IT SE**

(30) Priorité: **18.04.1997　FR 9704831**

(43) Date de publication de la demande:
**21.10.1998　Bulletin 1998/43**

(73) Titulaire: **Thales**
**75008 Paris (FR)**

(72) Inventeurs:
• **Solal, Marc, Thomson-CSF Prop. Intel.**
**94117 Arcueil cedex (FR)**
• **Dufilie, Pierre, Thomson-CSF Prop. Intel.**
**94117 Arcueil cedex (FR)**

(56) Documents cités:
**WO-A-97/12441**　　　　　DE-A- 4 439 489
**US-A- 5 365 138**

**Description**

La présente invention se rapporte aux dispositifs à ondes de surface, et en particulier aux filtres à ondes de surface à couplage par proximité qui sont utilisés dans de nombreuses applications, en particulier dans les téléphones portatifs.

Les filtres à ondes de surface utilisent la propagation des ondes acoustiques sur la surface d'un substrat piézo-électrique, et les caractéristiques de filtrage proviennent des modifications apportées à la propagation de ces ondes en fonction de leur fréquence par des électrodes convenablement disposées à la surface du substrat. Il existe plusieurs structures pour ces électrodes et on choisit entre elles en fonction des résultats à obtenir. Parmi ces structures, on connaît plus particulièrement celles qui utilisent des résonateurs couplés transversalement par proximité.

Le principe de base d'un filtre à résonateurs à couplage transverse est décrit, pour des raisons de clarté, en prenant comme exemple connu un filtre à deux pôles. Un tel filtre comprend deux résonateurs formés chacun d'un transducteur entre deux réseaux réflecteurs et couplés par proximité. Les transducteurs et les réseaux réflecteurs ont habituellement une période de métallisation d'environ une demi-longueur d'onde. Le premier résonateur est relié à l'entrée du filtre et le deuxième résonateur à la sortie. Le résonateur d'entrée comprend une électrode en forme de peigne dont les doigts sont interdigités avec les doigts d'une électrode de masse. Les ondes acoustiques ainsi générées par ce transducteur sont émises vers. la droite et vers la gauche vers des réflecteurs formés par des doigts parallèles aux doigts des transducteurs et obtenus par découpe de l'électrode de masse. Le résonateur relié à la sortie est symétrique du résonateur relié à l'entrée par rapport à un axe parallèle à la direction de propagation des ondes acoustiques générées par le résonateur d'entrée. Il comporte un transducteur et deux réflecteurs. La masse étant commune, l'électrode de masse correspondante est d'un seul tenant et elle est reliée à une sortie de masse. Le couplage des deux résonateurs se fait par proximité par le rapprochement entre eux. Dans ces conditions, on peut considérer au premier ordre que la structure est équivalente à celle obtenue en rapprochant deux guides d'ondes. Chacun des modes de propagation des guides considérés seuls se transforme en deux modes, un mode symétrique et un mode antisymétrique. Lorsque la distance entre les deux résonateurs est grande, les vitesses des ondes acoustiques dans ces deux modes sont très proches et sensiblement égales à la vitesse du mode d'un guide isolé. Le couplage est alors très faible, ce qui est d'autant plus évident que les résonateurs sont éloignés. Quand la distance entre les deux résonateurs diminue, les vitesses des ondes dans les deux modes s'écartent et le couplage augmente. On peut montrer que le schéma équivalent d'une telle structure correspond au premier ordre à celui obtenu pour deux résonateurs couplés avec un couplage égal à un écart normalisé entre les fréquences $f_s$ et $f_a$ des deux modes symétriques et antisymétriques donné par la formule :

$$k = 2 \frac{f_a - f_s}{f_a + f_s}$$

Ce couplage définit ainsi la bande passante relative que l'on peut obtenir avec ce type de filtre. En général, avec un filtre à deux pôles on obtient une réjection trop faible, ainsi qu'une raideur des flancs de la bande passante trop faible. On est alors amené à réaliser des filtres à quatre ou six pôles, voire plus, tout simplement en cascadant plusieurs structures à deux pôles.

L'inconvénient de cette structure réside dans la présence d'un bus central utilisé comme point commun, ce point commun étant relié à la masse. La caractéristique de ce bus interdit ainsi l'utilisation d'une liaison de type différentiel. Or une telle liaison est de plus en plus souvent nécessaire en raison de l'évolution des circuits intégrés vers une structure différentielle.

Un premier moyen pour obtenir un filtre à ondes de surface à couplage transverse à structure différentielle est connu de l'homme de l'art (US Patent 5,365,138). Il s'agit d'un filtre deux pôles à couplage transverse à entrées différentielles et à sortie différentielle ou non différentielle, dans lequel le transducteur du résonateur relié à l'entrée a été remplacé par deux transducteurs différents séparés par une demi-longueur d'onde. La masse est toujours commune et l'électrode correspondante d'un seul tenant, par contre chacun des transducteurs du résonateur relié à l'entrée est relié à une des entrées différentielles.

Une telle structure permet ainsi un fonctionnement différentiel, aussi bien en entrée qu'en sortie en séparant en deux parties le transducteur du résonateur relié à la sortie de la même manière que le transducteur du résonateur relié à l'entrée. Par contre, ce type de filtre présente un inconvénient majeur qui réside dans la forte impédance d'entrée du filtre. En effet, l'impédance d'entrée du filtre est la somme des impédances d'entrée de chacun des transducteurs car entre les deux entrées différentielles ils sont vus comme étant branchés en série par l'intermédiaire de l'électrode de masse. Pour remédier à ce problème, il existe une autre configuration qui présente une impédance d'entrée plus faible que celle du filtre précédent. L'idée de ce filtre consiste à utiliser directement le transducteur d'entrée en différentiel. C'est-à-dire que le transducteur est branché entre les entrées différentielles + et -. Une telle réalisation nécessite de séparer le bus central en deux, d'une part en un bus de masse faisant partie du résonateur relié à la sortie et d'autre part en un bus relié à une des entrées différentielles et faisant partie du résonateur relié à l'entrée.

Une telle structure permet ainsi un fonctionnement différentiel en entrée avec une impédance d'entrée faible égale à l'impédance du transducteur d'entrée. Par contre, elle présente un inconvénient important pour un fonctionnement en différentiel qui est l'absence de symétrie entre l'entrée différentielle + et l'entrée différentielle -.

Pour pallier cet inconvénient, on peut mettre en parallèle deux filtres selon la structure précédente pour réaliser un filtre à deux pôles à entrées différentielles (ref. : B.WALL, A. du Hamel : « Balanced driven transversely coupled resonator filters », 1996 IEEE Ultrasonics Symposium Proceedings). La symétrie entre l'entrée différentielle + et l'entrée différentielle - est obtenue en inversant la polarité des transducteurs pour compenser l'inversion de leurs entrées différentielles + et -.

Cette dernière structure de filtre permet ainsi un fonctionnement différentiel en entrée avec des entrées différentielles + et - totalement symétriques et une impédance d'entrée très faible, égale à la mise en parallèle des impédances de chacun des transducteurs. Par contre, elle nécessite une largeur de substrat importante pour être réalisée.

La présente invention a pour but de pallier les inconvénients précités.

A cet effet, l'invention a pour objet un dispositif à ondes acoustiques de surface utilisant un couplage par proximité d'un nombre entier N au moins égal à 2 de voies acoustiques de longueur de transduction donnée disposées parallèlement sur un substrat et numérotées successivement de 1 à N, caractérisé en ce qu'il comporte une première voie acoustique particulière comportant au moins un transducteur, comprenant deux bus de connexion prolongés par des électrodes, séparé en plusieurs parties reliées électriquement en parallèle entre elles pour former un premier et un deuxième ports différentiels, les polarités des différentes parties du transducteur étant choisies pour que le premier et le deuxième ports différentiels soient électriquement symétriques.

Selon une forme possible de réalisation, ce dispositif à ondes acoustiques de surface comporte en outre une deuxième voie acoustique particulière reliée à un troisième port utilisé préférentiellement comme une sortie du dispositif.

Selon un mode préférentiel de réalisation de l'invention, le dispositif est un filtre à ondes acoustiques de surface dont le premier et le deuxième ports sont utilisés préférentiellement comme une première et une deuxième entrées différentielles et dont chaque voie acoustique est composée d'un résonateur constitué d'un transducteur entre deux réseaux réflecteurs. Chaque transducteur comprend deux bus de connexion prolongés par des électrodes. Dans ce mode de réalisation, la symétrie électrique des deux entrées est obtenue en inversant les polarités des entrées des deux transducteurs, c'est-à-dire que les bus extérieurs (respectivement intérieurs) des deux transducteurs sont reliés aux deux tensions d'entrées opposées. Cette inversion de polarités des entrées peut être compensée soit en décalant les transducteurs d'une demi-longueur d'onde soit en branchant les électrodes de manière à ce que l'on conserve une alternance de polarités + et - à la jonction entre les deux demi-transducteurs.

Toujours de manière préférentielle, le résonateur relié à la sortie de ce filtre a la même structure que le résonateur relié à l'entrée permettant un fonctionnement différentiel en sortie du filtre aussi bien qu'en entrée.

Selon une autre caractéristique, le résonateur relié à la sortie de ce filtre comprend trois transducteurs de longueur égale respectivement à environ ¼, ½ et ¼ de la longueur totale de transduction du résonateur, ces transducteurs étant connectés électriquement en parallèle pour former deux sorties différentielles.

D'autres particularités et avantages de l'invention apparaîtront clairement dans la description suivante, d'exemples particuliers de réalisation. Les exemples choisis sont des filtres à ondes acoustiques de surface formés de plusieurs voies acoustiques, numérotées successivement de 1 à N, chaque voie acoustique de numéro n étant réalisée par un seul résonateur repéré par le même numéro n, ces voies étant disposées parallèlement sur un substrat. Dans la description, seul le terme résonateur est retenu. La description est faite en regard des figures annexées qui représentent :

-      la figure 1, un filtre à deux pôles selon un premier mode de réalisation de l'invention,
-      la figure 2, un schéma des électrodes du filtre représenté sur la figure 1,
-      la figure 3, un filtre à trois pôles selon un deuxième mode de réalisation de l'invention,
-      la figure 4, un filtre à deux pôles selon un troisième mode de réalisation de l'invention,
-      la figure 5, un schéma des électrodes du filtre représenté sur la figure 4,
-      la figure 6, un filtre à trois pôles selon un quatrième mode de réalisation de l'invention,
-      la figure 7, une représentation des différentes capacités mutuelles entre les transducteurs du filtre représenté sur la figure 4,
-      la figure 8, un filtre à deux pôles selon un cinquième mode de réalisation de l'invention,
-      la figure 9, un filtre à trois pôles selon un sixième mode de réalisation de l'invention.

Sur ces différentes figures, les éléments homologues sont représentés avec une même référence numérique ou une même référence alphanumérique.

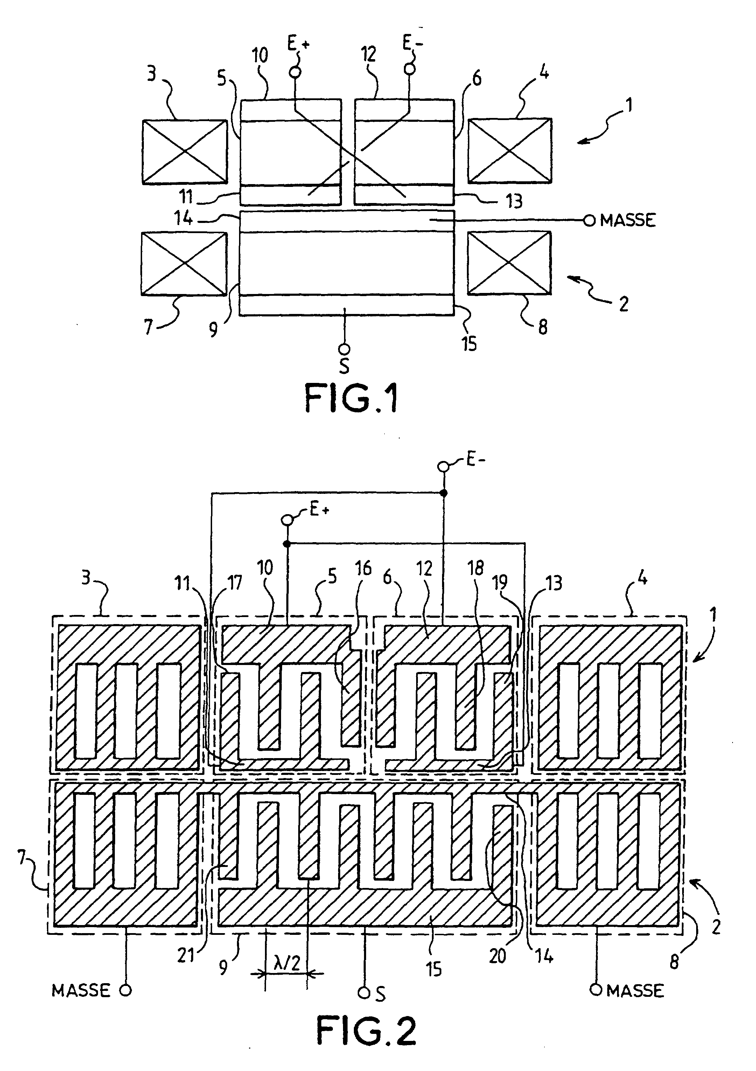

La figure 1 représente d'une manière schématique simple la structure d'un filtre à deux pôles et à entrées différentielles conforme à l'invention. Le filtre comporte deux entrées différentielles E+, E- entre lesquelles est appliqué le signal à filtrer et une sortie S pour restituer le signal filtré relativement à une référence de masse. Le filtre se compose de deux résonateurs 1 et 2 couplés par proximité. Le résonateur 1 relié aux entrées différentielles E+ et E- comprend deux réseaux réflecteurs 3 et 4 encadrant un transducteur séparé en deux parties pour former un premier transducteur 5 et un deuxième transducteur 6. Le résonateur 2 relié à la sortie S comprend deux réseaux réflecteurs 7 et 8 encadrant un seul transducteur 9. Chaque transducteur 5, 6 et 9 comprend deux bus de connexion respectivement 10 et 11, 12 et 13 et 14 et 15. Le bus de connexion 14 est relié à la masse. Le premier transducteur 5 est branché en parallèle avec le deuxième transducteur 6 pour former deux entrées différentielles E+ et E-. La symétrie entre les deux entrées différentielles E+ et E- est obtenue en inversant la polarité des bus de connexion entre le premier transducteur 5 et le deuxième transducteur 6. Cette inversion de polarité apparaît clairement sur la figure 2 qui donne une représentation schématique de la disposition des électrodes formant les différents transducteurs et réseaux réflecteurs des deux résonateurs 1 et 2. Pour des raisons de clarté, la structure représentée est très simple et comporte en particulier un petit nombre de doigts pour les électrodes. En réalité le nombre de doigts de chaque électrode est beaucoup plus élevé et conforme aux règles bien connues de l'homme de l'art. Le premier transducteur 5, représenté à l'intérieur d'une ligne fermée en pointillé, comprend une première électrode 16 reliée par l'intermédiaire du bus de connexion 10 à l'entrée différentielle E+, et une deuxième électrode 17 reliée par l'intermédiaire du bus de connexion 11 à l'entrée différentielle E-. Les doigts des deux électrodes, 16 et 17, sont imbriqués pour former une alternance de polarités électriques positive et négative et espacés d'environ une demi-longueur d'onde, $\lambda/2$. $\lambda$ étant la longueur d'onde de la fréquence centrale de fonctionnement du filtre. Le deuxième transducteur 6, représenté à l'intérieur d'une ligne fermée en pointillé, est disposé à côté du premier transducteur 5 suivant la direction de propagation des ondes acoustiques de surface. Le deuxième transducteur 6 comprend une première électrode 18 reliée par l'intermédiaire du bus de connexion 12 à l'entrée différentielle E-, et une deuxième électrode 19 reliée par l'intermédiaire du bus de connexion 13 à l'entrée différentielle E+. Suivant cette disposition, les polarités des bus de connexion des transducteurs, 5 et 6, sont inversées. Ceci permet d'obtenir la symétrie électrique des entrées E+ et E-. En effet, les bus 11 et 13 étant différents des bus 10 et 12, leurs impédances (par rapport à la masse et à la sortie S) ne sont pas équilibrées. Le fait de brancher en parallèle les bus 10 et 13 et les bus 11 et 12 permet d'équilibrer les entrées E+ et E- en branchant sur chacune des deux entrées un bus de chacun des deux types. En choisissant les polarités des doigts de manière à conserver une alternance de polarités électriques positives et négatives, on obtient un filtre à entrées différentielles dont l'impédance d'entrée est identique à celle d'un filtre similaire mais dont le transducteur du résonateur relié à l'entrée n'a pas été séparé en deux pour être utilisé en différentiel.

Le résonateur 1 relié aux entrées différentielles E+ et E-, est couplé par proximité au résonateur 2 relié à la sortie S. Le résonateur 2 relié à la sortie S comprend un seul transducteur 9, représenté à l'intérieur d'une ligne fermée en pointillé.

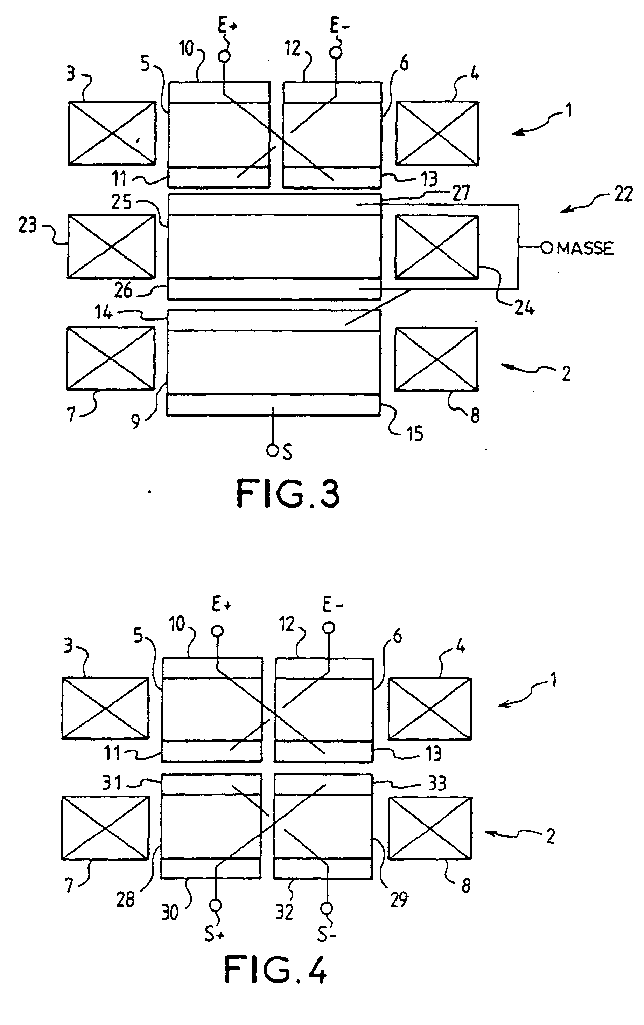

Le transducteur 9 comprend une première électrode 20, reliée à la sortie S par l'intermédiaire d'un bus de connexion 15, et une deuxième électrode 21, reliée à la masse par l'intermédiaire d'un bus de connexion 14. L'exemple utilisé plus haut pour décrire la structure de base d'un filtre selon l'invention est un filtre à deux pôles. Il est aisé d'améliorer la réjection du filtre selon l'invention ainsi que la raideur des flancs de la bande passante en utilisant un filtre à trois pôles à entrées différentielles. Un tel filtre selon l'invention est représenté sur la figure 3. Par rapport au filtre à deux pôles décrit précédemment en regard des figures 1 et 2, le filtre à trois pôles comprend un troisième résonateur 22 placé entre les résonateurs d'entrée et de sortie. Ce troisième résonateur 22 est couplé par proximité au résonateur 1 relié aux entrées différentielles, E+ et E-, et au résonateur 2 relié à la sortie S. Il n'est pas utilisé comme entrée ou sortie et est relié à la masse. Suivant cet exemple, il est possible de construire un filtre selon l'invention avec un nombre de pôles supérieur à trois, en ajoutant des résonateurs entre le résonateur 1 relié aux entrées différentielles, E+ et E-, et le résonateur 2 relié à la sortie S, ou en ajoutant des résonateurs sur le substrat, à l'extérieur du bloc formé du résonateur 1 et du résonateur 2, du côté du résonateur 1 ou du côté du résonateur 2.

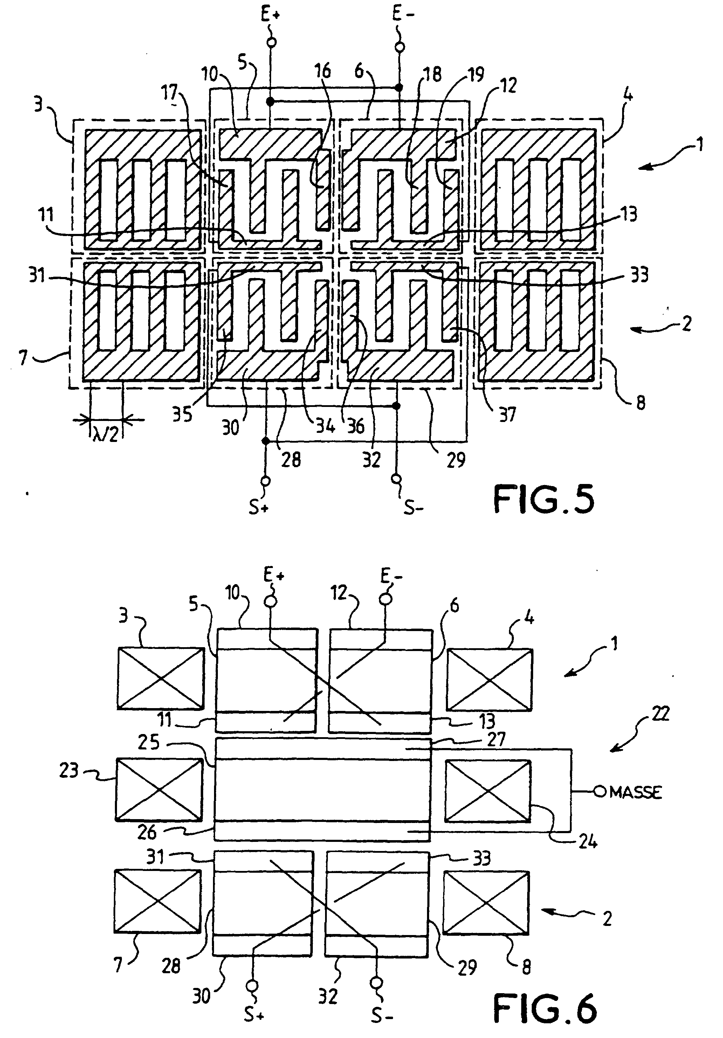

Dans les exemples utilisés précédemment pour décrire l'invention, la sortie S est non différentielle. Il est cependant tout à fait possible dans le cadre de l'invention d'utiliser, comme représenté sur la figure 4, un résonateur relié à la sortie identique au résonateur relié à l'entrée. Le résonateur 2 relié aux sorties différentielles, S+ et S-, comprend deux réseaux réflecteurs 7 et 8 encadrant un transducteur séparé en deux parties pour former un premier transducteur 28 et un deuxième transducteur 29. Le premier et le deuxième transducteurs, 28 et 29 comportent chacun deux bus de connexion, respectivement 30 et 31, et 32 et 33. Le premier transducteur 28 est branché en parallèle avec le deuxième transducteur 29 pour former deux sorties différentielles, S+ et S-. La symétrie entre les sorties différentielles S+ et S- est obtenue en inversant la polarité des bus de connexion, 30 et 32 d'une part et 31 et 33 d'autre part, entre le premier transducteur 28 et le deuxième transducteur 29. L'inversion de polarité apparaît clairement sur la figure 5 qui donne une représentation schématique, du même style que la représentation utilisée pour la figure 2, de la disposition des électrodes formant les différents transducteurs et réseaux réflecteurs des deux résonateurs, 1 et 2. L'exemple de filtre représenté sur la figure 5 présente un résonateur 2 relié aux sorties différentielles, S+ et S-, dont la structure est symétrique de celle du résonateur 1 relié aux entrées différentielles, E+ et E-, par rapport à l'axe de propagation des ondes acoustiques.

De même que pour le filtre à sortie non différentielle illustré par les figures 1, 2 et 3, il est aisé d'améliorer la réjection ainsi que la raideur des flancs de la bande passante du filtre à sorties différentielles selon l'invention, en utilisant un filtre à trois pôles. Celui-ci est illustré par la figure 6. De la même manière que le filtre représenté sur la figure 3, le filtre représenté sur la figure 6 est un filtre à trois pôles réalisé avec un troisième résonateur placé entre les deux résonateurs du filtre à deux pôles illustré par les figures 4 et 5.

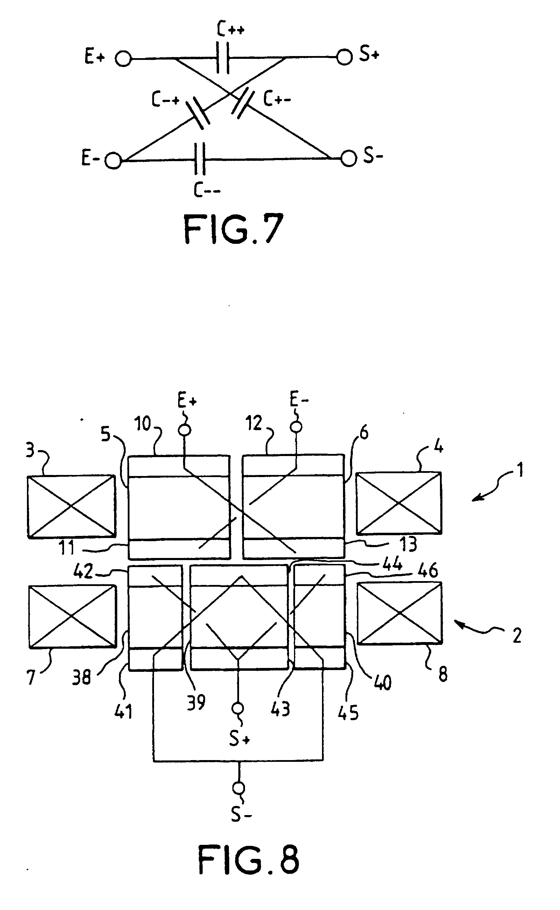

Ainsi la structure de filtre illustrée par les figures 4, 5 et 6 présente l'avantage d'une symétrie aussi bien entre les deux entrées différentielles, E+ et E-, qu'entre les deux sorties différentielles, S+ et S-. Toutefois, un point important qui intervient sur la réjection est l'équilibrage des capacités mutuelles entre le transducteur du résonateur lié à l'entrée et le transducteur du résonateur lié à la sortie, dans le cas d'un filtre à deux résonateurs couplés par proximité illustré par la figure 4. Ces capacités peuvent être schématisées comme illustré sur la figure 7. L'équilibrage des mutuelles est réalisé quand les relations suivantes sont satisfaites :

$$C_{++} = C_{-+} \qquad (1)$$

$$C_{--} = C_{+-} \qquad (2)$$

Dans ces conditions, il n'y a pas de passage direct capacitif entre l'entrée et la sortie. Les relations (1) et (2) ne sont pas satisfaites avec la structure du filtre représenté sur les figures 4 et 5. La géométrie de cette structure permet seulement d'écrire que :

$$C_{++} = C_{--} \qquad (3)$$

$$C_{+-} = C_{-+} \qquad (4)$$

Les relations (3) et (4) ne permettent pas la suppression du passage direct entre l'entrée et la sortie par couplage capacitif comme cela est le cas avec une structure dont la sortie est non différentielle.

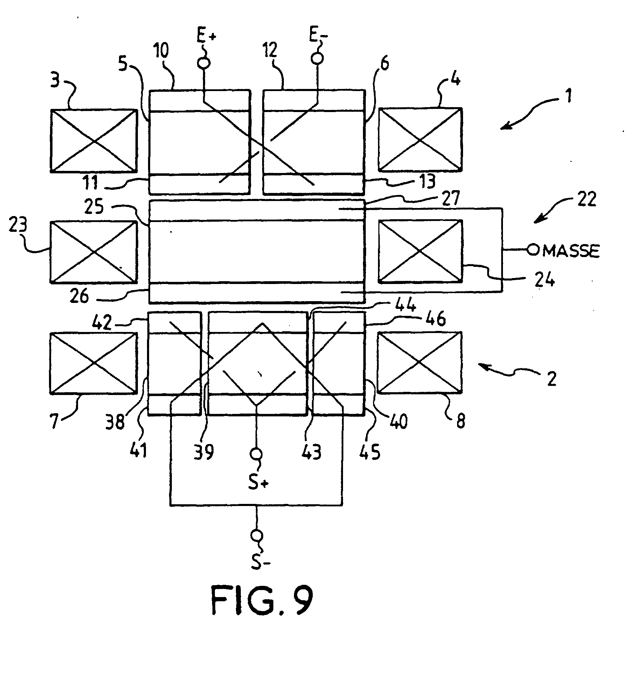

Une variante à l'invention permet de remédier à cet inconvénient. La structure du filtre correspondant est représentée sur les figures 8 et 9.

La figure 8 représente un filtre à deux pôles. Pour réduire le passage direct entre l'entrée et la sortie, la structure représentée sur les figures 4 et 5 a été modifiée au niveau du résonateur 2 relié aux sorties différentielles, S+ et S-. Le transducteur du résonateur 2 relié aux sorties différentielles, S+ et S-, est découpé en trois parties pour former un premier transducteur 38, un deuxième transducteur 39 et un troisième transducteur 40, comprenant chacun deux bus de connexion, respectivement 41 et 42, 43 et 44 et 45 et 46. La longueur de chacun des transducteurs est respectivement environ ¼, ½ et ¼ de la longueur de transduction du résonateur 1 relié aux entrées différentielles, E+ et E- définie par la longueur totale des transducteurs de ce résonateur.

Les trois transducteurs, 38, 39 et 40 disposés l'un à côté de l'autre, sont branchés en parallèle en respectant les règles déjà décrites précédemment en regard de la figure 1. Dans ces conditions, la structure du filtre présente simultanément une symétrie entre les entrées différentielles, E+ et E-, une symétrie entre les sorties différentielles, S+ et S-, et une symétrie entre les capacités mutuelles. La figure 9 représente la même structure de filtre pour un filtre à trois pôles. L'invention a été essentiellement décrite avec des filtres à deux pôles et à trois pôles. Des filtres selon l'invention à nombre de pôles supérieur peuvent être réalisés en cascadant des filtres à deux pôles ou à trois pôles ou bien en couplant un nombre de résonateurs suffisants suivant le principe décrit en regard des figures 3, 6 et 9. D'autre part, dans certains cas, des transducteurs seuls ont un fonctionnement identique à celui d'un résonateur et les réseaux peuvent alors être très courts (par exemple 10 à 50 doigts) ou inexistant. Les résonateurs non reliés aux entrées ou sorties dans le cas des filtres à nombre de pôles supérieur à deux ont été décrits comme étant composés d'un transducteur entre deux réseaux mais ces résonateurs étant reliés à la masse, le transducteur pourra être avantageusement remplacé par un réseau de traits en court circuit. Enfin, on a considéré dans les exemples précédents que chaque voie acoustique était constituée d'un résonateur, ces résonateurs ayant un seul mode de résonance. On peut évidemment généraliser l'invention à tout type de dispositif à ondes de surface utilisant un couplage par proximité de plusieurs voies acoustiques que ces voies acoustiques soient constituées par des résonateurs ou non. En particulier, il est possible de réaliser un dispositif comportant sur la même voie acoustique une entrée attaquée en différentiel et une sortie.

L'invention a été essentiellement décrite en regard d'exemples particuliers de filtres à ondes acoustiques de surface équipés d'entrées différentielles. L'invention s'applique, suivant le même principe à des dispositifs équipés d'une seule entrée et de sorties différentielles.

On peut également réaliser un dispositif ne comprenant pas de sortie, seule l'impédance vue entre les entrées étant utilisée, pour réaliser un filtre par exemple.

## Revendications

1. Dispositif à ondes acoustiques de surface utilisant un couplage par proximité d'un nombre entier N au moins égal à 2 de voies acoustiques (1, 2, 22) de longueur de transduction donnée disposées parallèlement sur un substrat et numérotées successivement de 1 à N, qui comporte une première voie acoustique particulière (1, 2) comportant au moins un transducteur, comprenant deux bus de connexion (10, 11), (12, 13) (14, 15), (26, 27), (30, 31), (32, 33) prolongés par des électrodes **caractérisé en ce que** le transducteur est séparé en plusieurs parties (5, 6), (28, 29), (34, 35, 36) reliées électriquement en parallèle entre elles pour former un premier (E+) et un deuxième (E-) ports différentiels, les polarités de connexion des différentes parties (5, 6), (28, 29), (34, 35, 36) du transducteur étant inversées l'une par rapport à l'autre et ainsi choisies pour que le premier (E+) et le deuxième (E-) ports différentiels soient électriquement symétriques.

2. Dispositif selon la revendication 1, **caractérisé en ce qu'**il comporte une deuxième voie acoustique particulière (2, 1) reliée à un troisième (S) port.

3. Dispositif selon la revendication 2, **caractérisé en ce que** la première voie acoustique particulière correspond à la voie acoustique numérotée 1 (1) du dispositif et **en ce que** la deuxième voie acoustique particulière correspond à la voie acoustique numérotée N (2) du dispositif et **en ce que** le premier et le deuxième ports différentiels réalisent une première (E+) et une deuxième (E-) entrées différentielles du dispositif et **en ce que** le troisième port réalise une sortie (S) du dispositif.

4. Dispositif selon la revendication 3, **caractérisé en ce que** la voie acoustique numérotée N (2) comporte au moins un transducteur séparé en plusieurs parties (28, 29), (34, 35, 36) reliées électriquement en parallèle entre elles réalisant un partage de la sortie (S) en une première (S+) et une deuxième (S-) sorties différentielles, les polarités de connexion des différentes parties (28, 29), (34, 35, 36) du transducteur étant inversées l'une par rapport à l'autre et ainsi choisies pour que la première (S+) et la deuxième (S-) sorties différentielles soient électriquement symétriques.

5. Dispositif selon l'une quelconque des revendications 3 et 4, **caractérisé en ce que** les parties du transducteur de la voie acoustique numérotée 1 (1) ont une longueur égale respectivement à environ ¼, ½ et ¼ de la longueur de transduction de cette même voie.

6. Dispositif selon la revendication 4, **caractérisé en ce que** les parties (34, 35, 36) du transducteur de la voie acoustique numérotée N (2) ont une longueur égale respectivement à environ ¼, ½ et ¼ de la longueur de transduction de cette même voie.

7. Dispositif selon l'une quelconque des revendications 1 à 6, **caractérisé en ce que** les électrodes (16, 17), (18, 19) du transducteur de la première voie acoustique particulière (1) sont découpées pour former une succession régulière de doigts (16, 17) (18, 19) imbriqués formant une alternance de polarités électriques positive et négative.

8. Dispositif selon l'une quelconque des revendications 1 à 7, **caractérisé en ce que** chacune des N voies acoustiques couplées par proximité est constituée d'un résonateur composé d'un transducteur entre deux réseaux réflecteurs (3, 4), (7, 8), (23, 24).

9. Dispositif selon la revendication 8, **caractérisé en ce que** le résonateur (1) de la voie acoustique numéroté 1 et le résonateur (2) de la voie acoustique numérotée N présentent une structure identique symétrique entre elles par rapport à l'axe de propagation des ondes acoustiques de surface.

10. Dispositif selon la revendication 2, **caractérisé en ce que** la première voie acoustique particulière correspond à la voie acoustique numérotée N (2) du dispositif et **en ce que** la deuxième voie acoustique particulière correspond à la voie acoustique numérotée 1 (1) du dispositif et **en ce que** le premier et le deuxième ports différentiels réalisent une première (S+) et une deuxième (S-) sorties différentielles du dispositif et **en ce que** le troisième port réalise une entrée du dispositif.

11. Dispositif selon la revendication 10, **caractérisé en ce que** les parties (34, 35, 36) du transducteur de la voie acoustique numérotée N (2) ont une longueur égale respectivement à environ ¼, ½ et ¼ de la longueur de transduction de cette même voie.

12. Dispositif selon l'une quelconque des revendications 10 et 11, **caractérisé en ce que** les électrodes (34, 35) (36, 37) du transducteur de la voie acoustique numérotée N (2) sont découpées pour former une succession régulière de doigts (34, 35) (36, 37) imbriqués formant une alternance de polarités électriques positive et négative.

13. Dispositif selon l'une quelconque des revendications 10 à 12, **caractérisé en ce que** chacune des N voies acoustiques couplées par proximité est constituée d'un résonateur composé d'un transducteur entre deux réseaux réflecteurs (3, 4), (7, 8), (23, 24).

**Patentansprüche**

1. Akustische Oberflächenwellenvorrichtung, die eine Nahfeldkopplung einer ganzen Zahl N mindestens gleich 2 von Akustikkanälen (1, 2, 22) einer gegebenen Wandlungslänge verwendet, die parallel auf einem Substrat angeordnet und nacheinander von 1 bis N nummeriert sind, wobei die Vorrichtung einen bestimmten ersten Akustikkanal (1, 2) aufweist, der mindestens einen Wandler enthält, der zwei Verbindungsleitungen (10, 11), (12, 13) (14, 15), (26, 27), (30,31), (32, 33) besitzt, die durch Elektroden verlängert werden, **dadurch gekennzeichnet, dass** der Wandler in mehrere Bereiche (5, 6), (28, 29), (34, 35, 36) aufgeteilt ist, die elektrisch untereinander parallelgeschaltet sind, um einen ersten (E+) und einen zweiten differentiellen Anschluss (E-) zu bilden, wobei die Verbindungspolaritäten der verschiedenen Bereiche (5, 6), (28, 29), (34, 35, 36) des Wandlers einander entgegengerichtet und so gewählt sind, dass der erste (E+) und der zweite differentielle Anschluss (E-) elektrisch zueinander symmetrisch sind.

2. Vorrichtung nach Anspruch 1, **dadurch gekennzeichnet, dass** sie einen bestimmten zweiten Akustikkanal (2, 1) aufweist, der mit einem dritten Anschluss (S) verbunden ist.

3. Vorrichtung nach Anspruch 2, **dadurch gekennzeichnet, dass** der bestimmte erste Akustikkanal dem mit 1 (1) nummerierten Akustikkanal der Vorrichtung entspricht, und dass der bestimmte zweite Akustikkanal dem mit N (2) nummerierten Akustikkanal der Vorrichtung entspricht, und dass der erste und der zweite differentielle Anschluss einen ersten (E+) bzw. einen zweiten (E-) differentiellen Eingang der Vorrichtung bilden, während der dritte Anschluss einen Ausgang (S) der Vorrichtung bildet.

4. Vorrichtung nach Anspruch 3, **dadurch gekennzeichnet, dass** der mit N (2) nummerierte Akustikkanal mindestens einen Wandler aufweist, der in mehrere Bereiche (28, 29), (34, 35, 36) aufgeteilt ist, die elektrisch parallelgeschaltet sind und eine Aufteilung des Ausgangs (S) in einen ersten (S+) und einen zweiten (S-) differentiellen Ausgang bilden, wobei die Verbindungspolaritäten der verschiedenen Bereiche (28, 29), (34, 35, 36) des Wandlers einander entgegengerichtet und so ausgewählt sind, dass der erste (S+) und der zweite (S-) differentielle Ausgang elektrisch zueinander symmetrisch sind.

5. Vorrichtung nach einem der Ansprüche 3 und 4, **dadurch gekennzeichnet, dass** die Bereiche des Wandlers des mit 1 (1) nummerierten Akustikkanals eine Länge gleich etwa 1/4, 1/2 und 1/4 der Wandlungslänge dieses gleichen Kanals haben.

6. Vorrichtung nach Anspruch 4, **dadurch gekenn-**

**zeichnet, dass** die Bereiche (34, 35, 36) des wandlers des mit N (2) nummerierten Akustikkanals eine Länge gleich etwa 1/4, 1/2 und 1/4 der Wandlungslänge dieses gleichen Kanals haben.

7. Vorrichtung nach einem der Ansprüche 1 bis 6, **dadurch gekennzeichnet, dass** die Elektroden (16, 17), (18, 19) des Wandlers des bestimmten ersten Akustikkanals (1) ausgeschnitten sind, um eine regelmäßige Folge von ineinander verschachtelten Fingern (16, 17) (18, 19) zu bilden, die eine alternierende Folge von positiven und negativen elektrischen Polaritäten bilden.

8. Vorrichtung nach einem der Ansprüche 1 bis 7, **dadurch gekennzeichnet, dass** jeder der nahfeldgekoppelten N Akustikkanäle aus einem Resonator besteht, der aus einem Wandler zwischen zwei Reflexionsgittern (3, 4), (7, 8), (23, 24) zusammengesetzt ist.

9. Vorrichtung nach Anspruch 8, **dadurch gekennzeichnet, dass** der Resonator (1) des mit 1 nummerierten Akustikkanals und der Resonator (2) des mit N nummerierten Akustikkanals bezüglich der Ausbreitungsachse der akustischen Oberflächenwellen gleiche, zueinander symmetrische Strukturen aufweisen.

10. Vorrichtung nach Anspruch 2, **dadurch gekennzeichnet, dass** der bestimmte erste Akustikkanal dem mit N (2) nummerierten Akustikkanal der Vorrichtung entspricht, und dass der bestimmte zweite Akustikkanal dem mit 1 (1) nummerierten Akustikkanal der Vorrichtung entspricht, und dass der erste und der zweite differentielle Anschluss einen ersten (S+) bzw. einen zweiten (S-) differentiellen Ausgang der Vorrichtung bilden, während der dritte Anschluss einen Eingang der Vorrichtung bildet.

11. Vorrichtung nach Anspruch 10, **dadurch gekennzeichnet, dass** die Bereiche (34, 35, 36) des Wandlers des mit N (2) nummerierten Akustikkanals eine Länge aufweisen, die je etwa 1/4, 1/2 und 1/4 der Wandlungslänge dieses gleichen Kanals entspricht.

12. Vorrichtung nach einem der Ansprüche 10 und 11, **dadurch gekennzeichnet, dass** die Elektroden (34, 35) (36, 37) des Wandlers des mit N (2) nummerierten Akustikkanals so ausgeschnitten sind, dass sie eine regelmäßige Folge von ineinander verschachtelten Fingern (34, 35) (36, 37) zu bilden, die eine alternierende Folge von positiven und negativen elektrischen Polaritäten bilden.

13. Vorrichtung nach einem der Ansprüche 10 bis 12, **dadurch gekennzeichnet, dass** jeder der nahfeldgekoppelten N Akustikkanäle aus einem Resonator besteht, der aus einem Wandler zwischen zwei Reflexionsgittern (3, 4), (7, 8), (23,24) zusammengesetzt ist.

**Claims**

1. Surface acoustic wave device using a proximity coupling of a whole number N of acoustic channels (1,2,22), where N is at least equal to 2, with a given transduction length, these acoustic channels being positioned in parallel on a substrate and numbered successively from 1 to N, which comprises a first particular acoustic channel (1,2) comprising at least one transducer, comprising two connection buses (10,11), (12,13), (14,15), (26,27), (30,31), (32,33) extended by electrodes, **characterized in that** the transducer is separated into several parts (5,6), (28,29), (34,35,36) electrically connected in parallel with one another to form a first differential port (E+) and a second differential port (E-), the connection polarities of the different parts (5,6), (28,29), (34,35,36) of the transducer being reversed with respect to one another and thus chosen so that the first differential port (E+) and the second differential port (E-) are electrically symmetrical.

2. Device according to Claim 1, **characterized in that** it comprises a second particular acoustic channel (2,1) connected to a third port (S).

3. Device according to Claim 2, **characterized in that** the first particular acoustic channel corresponds to the acoustic channel numbered 1 (1) of the device and **in that** the second particular acoustic channel corresponds to the acoustic channel numbered N (2) of the device and **in that** the first differential port and the second differential port form a first differential input (E+) and a second differential input (E-) of the device and **in that** the third port forms an output (S) of the device.

4. Device according to Claim 3, **characterized in that** the acoustic channel numbered N (2) comprises at least one transducer separated into several parts (28,29), (34,35,36) that are electrically connected in parallel to one another, achieving a subdivision of the output (S) into a first differential output (S+) and a second differential output (S-), the connection polarities of the different parts (28,29),(34,35,36) of the transducer being reversed with respect to one another and thus chosen so that the first differential output (S+) and the second differential output (S-) are electrically symmetrical.

5. Device according to Claim 4, **characterized in that** the parts of the transducer of the acoustic channel numbered 1 (1) have a length equal respectively to about ¼, ½ and ¼ of the transduction length of this same channel.

6. Device according to Claim 4, **characterized in that** the parts (34,35,36) of the transducer of the acoustic channel numbered N (2) have a length equal respectively to about ¼, ½ and ¼ of the transduction length of this same channel.

7. Device according to Claim 1, **characterized in that** the electrodes (16,17),(18,19) of the transducer of the first particular acoustic channel (1) are cut out to form a regular succession of imbricated fingers (16,17), (18,19) forming an alternation of positive and negative electrical polarities.

8. Device according to Claim 1, **characterized in that** each of the N acoustic channels coupled by proximity is constituted by a resonator consisting of a transducer between two reflector gratings (3,4), (7,8), (23,24).

9. Device according to Claim 8, **characterized in that** the resonator (1) of the acoustic channel numbered 1 and the resonator (2) of the acoustic channel numbered N have an identical structure, symmetrical with each other with respect to the axis of propagation of the surface acoustic waves.

10. Device according to Claim 2, **characterized in that** the first particular acoustic channel corresponds to the acoustic channel numbered N (2) of the device and **in that** the second particular acoustic channel corresponds to the acoustic channel numbered 1 (1) of the device and **in that** the first differential port and the second differential port form a first differential output (S+) and a second differential output (S-) of the device, and **in that** the third port forms an input of the device.

11. Device according to Claim 10, **characterized in that** the parts (34,35,36) of the transducer of the acoustic channel numbered N (2) have a length equal respectively to about ¼, ½ and ¼ one-fourth of the transduction length of this same channel.

12. Device according to Claim 10, **characterized in that** the electrodes (34,35),(36,37) of the transducer of the acoustic channel numbered N (2) are cut out to form a regular succession of imbricated fingers (34,35), (36,37) forming an alternation of positive and negative electrical polarities.

13. Device according to Claim 12, **characterized in that** each of the N acoustic channels coupled by proximity is constituted by a resonator consisting of a transducer between two reflector gratings (3,4), (7,8), (23,24).

FIG.1

FIG.2

FIG.3

FIG.4

FIG.5

FIG.6

FIG.7

FIG.8

FIG. 9